# EUROPEAN PATENT SPECIFICATION

(11) **EP 2 433 319 B1**
(45) Date of publication and mention of the grant of the patent: **05.06.2019**
(21) Application number: 10719465.6
(22) Date of filing: 21.04.2010
(51) Int. Cl.: H01L 51/52

(54) **HERMETIC ELECTRICAL PACKAGE**
HERMETISCHE ELEKTRISCHE KAPSELUNG
ENVELOPPE ÉLECTRIQUE HERMÉTIQUE

(30) Priority: 21.05.2009 US 470033
(43) Date of publication of application: 28.03.2012
(73) Proprietor: BOE Technology Group Co., Ltd., Chaoyang District Beijing (CN)
(72) Inventor: FARQUHAR, Donald, Seton, Niskayuna NY 12309 (US); HERZOG, Michael, Scott, Voorheesville NY 12186 (US); RAKUFF, Stefan, Clifton Park NY 12065 (US)
(74) Representative: Klunker IP Patentanwälte PartG mbB
(86) International application number: PCT/US2010/031854
(87) International publication number: WO 2010/135050

(56) References cited:
- WO-A1-2007/023789
- WO-A2-2007/036850
- US-A1- 2002 043 932
- US-A1- 2005 093 001
- US-A1- 2005 233 503

## Description

### BACKGROUND

Optoelectronic devices generally include light-emitting devices and photovoltaic devices. These devices generally include an active layer sandwiched between two electrodes, sometimes referred to as the front and back electrodes, at least one of which is typically transparent. The active layer typically includes one or more semiconductor materials. In a light-emitting device, e.g., an organic light-emitting diode (OLED), a voltage applied between the two electrodes causes a current to flow through the active layer. The current causes the active layer to emit light. In a photovoltaic device, e.g., a solar cell, the active layer absorbs energy from light and converts this energy to electrical energy exhibited as a voltage and/or current between the two electrodes. Optoelectronic devices may be produced by various means. One approach is to use vacuum deposition of semiconductor materials, and a second approach is to use solution processed materials. Various substrates including glass and plastic film can be used as a base for depositing the layers on. Alternately, the optoelectronic device may be built using the opaque layer (metal or polymer or ceramic) as the substrate and an alternate build sequence is employed. Regardless of the construction of the device, it is necessary to provide an encapsulating hermetic package to protect it from the deteriorating effects of moisture and oxygen exposure. The package must also provide electrical interconnections in a feedthrough configuration to connect a power supply that is external to the package.

OLEDs are produced in a flat thin format for use as displays or for general illumination. The use of a plastic substrate provides the thinnest and most flexible configuration, and also the potential for low cost roll-to-roll production. Accordingly, there is a need for packaging technology that is also thin and flexible, and preferably amenable to roll-to-roll production coincident with the OLED fabrication. The package should be suitable for large area (up to about one or more square meters) displays or luminaries for particular applications.

Barrier films, referred to as ultra high barrier (UHB) films or UHBs, are used for direct fabrication of OLEDs and other optoelectronic devices. These films typically consist of a thin transparent oxide layer on a transparent plastic film, for example, as described in US 7,015,640, US 7,154,220, and US 7,397,183 assigned to the General Electric Company. However, the barrier films can be damaged in handling, so that fabricating a device directly on the barrier film may degrade its performance and create a moisture ingress path. In addition, moisture and oxygen can permeate laterally through adhesive layers at the edges of the device and also through the adhesive that seals the electrical wire feedthroughs. Moreover, intrinsic moisture in the adhesive and substrate materials can damage the device. The package design must be compatible with low cost materials and continuous roll-to-roll production, and the material set must be low cost and suitable for high speed processing. Thus, there is a need for an improved thin flexible packaging technology for expanded application of low cost production of OLEDs and other optoelectronic devices.

US 2005/233503 A1 discloses a method for the patterned coating of a substrate with at least one surface, wherein the method includes the steps of: producing at least one negatively patterned first coating on the at least one surface, depositing at least one second layer, which includes a material with a vitreous structure, on the surface, and at least partially removing the first coating.

US 2002/043932 A1 discloses an organic electroluminescence device including a transparent substrate, an electrode film, a transparent electrode film, a first insulating film having an opening, an organic electroluminescence light emitting film, a metal electrode film and a second insulating film. The first and second insulating films exhibit gas barrier characteristics. The opening is tapered so that its opening degree is increased in a direction away from the transparent electrode film side. The transparent electrode film is electrically connected via electrode film to a first electrode formed on the second insulating film as it is passed through the first and second insulating films to be exposed on the second insulating film. The metal electrode film is electrically connected to a second electrode passed through the second insulating film to be exposed on the second insulating film.

US 2005/093001 A1 discloses an organic electro-optic device and a method for making the same. The method comprises the steps of: forming a first component comprising at least one first material on a first substrate; forming a second component comprising at least one second material on a second substrate, wherein at least one opening is formed through the second component; forming a third component; and laminating the first component, the second component and the third component together such that the second component is located between the first component and the third component, the at least one first material and the at least one second material form at least part of an organic electro-optic device located between the first substrate and the second substrate, the third component is bonded to the second component, and the third component is bonded to the first component through the at least one opening.

### BRIEF DESCRIPTION

It is an object of the present invention to provide an improved thin flexible packaging technology for expanded application of low cost production of OLEDs and other optoelectronic devices, particularly to provide a hermetic electrical package and a manufacturing process thereof.

The object is achieved by the features of independent claim 1 providing a hermetic electrical package.

The object is further achieved by the features of independent claim 11 providing a process for manufacturing a hermetic electrical package.

Further embodiments are defined in the respective dependent claims.

### DRAWINGS

These and other features, aspects, and advantages of the present invention will become better understood when the following detailed description is read with reference to the accompanying drawings in which like characters represent like parts throughout the drawings, wherein:
FIGS. 1A and 1B are cross-sectional views of optoelectronic devices that include a transparent barrier layer.
FIG. 2A and 2B are cross-sectional views of hermetic electrical packages that include internal conductive patches.
FIG. 3 is a cross-sectional view of a hermetic electrical package including external conductive patches.
FIG. 4 is a cross-sectional view of a hermetic electrical package including a multilayered backsheet with conductive patches within the layers.
FIG. 5 is a cross-sectional view of a hermetic electrical package showing external electrical connectors.
FIG. 6 is a plan view of a hermetic electrical package.
FIG. 7 is a schematic illustration of a roll-to-roll process for manufacturing a hermetic electrical package.

### DETAILED DESCRIPTION

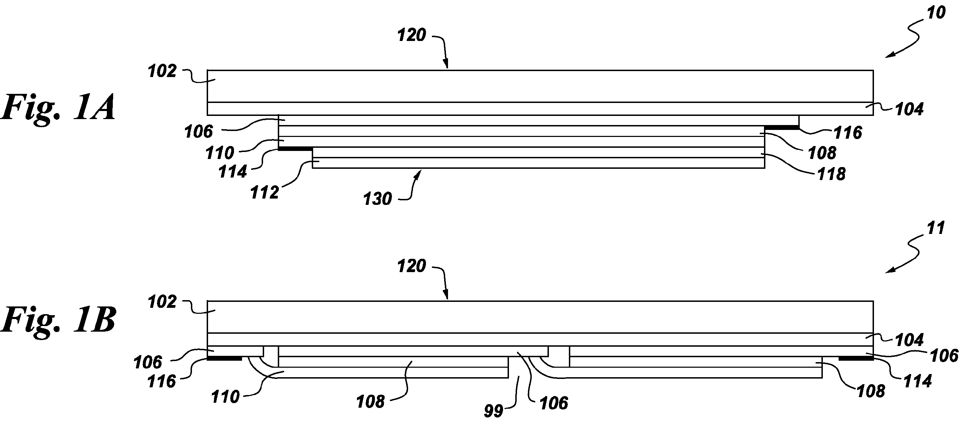

FIG. 1A illustrates combination optoelectronic device 10, which may be a light-emissive device, particularly, an OLED, or a light-absorbing device, such as a photovoltaic (PV) cell, and includes plastic or glass substrate 102, transparent barrier layer 104, transparent conductive layer 106 forming a first electrode (typically an anode), optoelectronically active layer 108, and second electrode (cathode) 110. In some embodiments, the transparent barrier layer is present in a different location, and in others, the transparent barrier layer is absent. Additional layers such as hole injecting, hole transporting, electron injection and electron transporting layers are frequently included in an OLED, and may be present in a hermetic packaged device according to the present invention but are not critical. Layer 118 is an optional insulating layer that may be used to provide mechanical protection to the cathode during fabrication and/or to prevent electrical shorting to other package elements during subsequent steps. Layer 112 is an optional barrier layer to protect the device. Cathode contact 114 and anode contact 116 are used to form an electrical connection to energize the device. Optoelectronic device 10 is shown diagrammatically as a single pixel device, but it is known in the art that individual pixels can be monolithically integrated in a series configuration, and that the exact location of contacts 114 and 116 may be varied based on various design considerations. FIG. 1A depicts optional second barrier layer 112 to provide additional protection to the cathode, and may be omitted in some embodiments as depicted in FIG. 1B. In combination 10, surface 120 is the light emitting or light absorbing side, and surface 130 is the non-emitting backside. It is known in the art that an OLED may be fabricated in various configurations and by various processes. For example, US 6,661,029, US 6,700,322, US 6,800,999 and US 6,777,871, assigned to General Electric Company, describe OLED devices that may be included in a hermetic package according to present invention, and methods for manufacturing them.

FIG. 1B depicts optoelectronic device 11 having a series interconnect configuration between adjacent pixels. Series interconnection of OLED devices is described in US 7,049,757. In device 11, layers 102, 104, 106, 108, 112, 118, and surfaces 120 and 130 are the same as in device 10. In device 11, two or more pixels are monolithically connected in series, and the device is then connected to a power supply by means of electrical contacts 114 and 116. The monolithic interconnection 99 is formed by electrically isolating anodes 106 of adjacent pixels, electrically isolating cathodes 110 of adjacent pixels, and then connecting the cathode of one pixel to the anode of the adjacent pixel. In the case of photovoltaic devices, interconnect zone 99 is formed by a process known as scribing, and the device is connected to the external load by means of electrical contacts 114 and 116. Devices configured as shown in FIG. 1B operate at the current level of single pixel and a voltage level determined by the sum of the individual cells. Reducing the current flow is important in large devices where the lateral flow of electrical current results in resistive losses. Figures 1A and 1B are suited to disposing the contacts 114 and 116 in close proximity to the perimeter of the substrate 102, thus being suited to packaging techniques that provide feedthrough connections through the edge of the package.

Combinations of design elements of FIG. 1A and 1B can be used to configure devices or sets of devices in such a way to tailor the voltage-current characteristics, to combine individual devices in a tiling configuration and/or to provide tuning of brightness levels of individual devices.

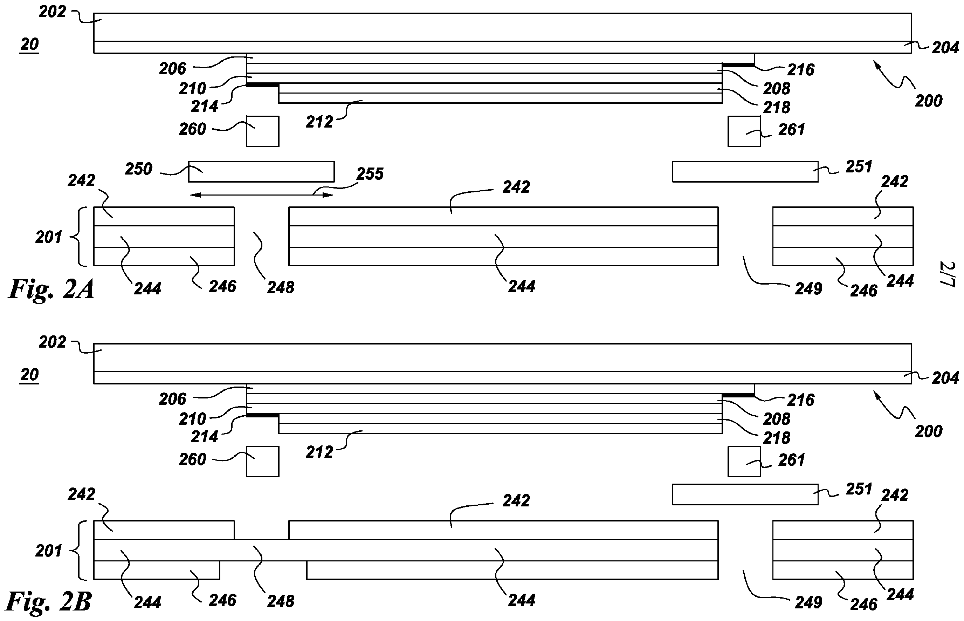

FIG. 2A shows an exploded view of hermetic electrical package 20 composed of combination optoelectronic device/transparent barrier layer sheet 200 and second barrier layer (backsheet) 201. Combination sheet 200 includes substrate 202 and transparent barrier layer 204, as well as electrode 206, optoelectronically active layer 208, and second electrode 210. Combination 200 includes transparent substrate 202, transparent barrier layer 204, transparent conductive layer 206 forming a first electrode (typically an anode), optoelectronically active layer 208, and second electrode (cathode) 210, optional insulating layer 218, contacts 214 and 216 and optional second barrier layer 212. Suitable materials suitable for transparent substrate 202 include transparent flexible plastics, such as polyesters and polycarbonates, particularly optical grades of such plastics. Suitable materials for barrier layer 204 include those having a moisture permeability rate less than approximately 10⁻⁴ cc/m² /day, preferably less than 10⁻⁵ cc/m² /day, and more preferably less than approximately 10⁻⁶ cc/m² /day (at 23°C), particularly UHB materials, such as described in US 7,015,640, US 6,413,645, US 6,492026, US 6,537,688, and US 6,624,568, flexible or rigid glass, transparent metals and oxides having sufficient moisture and/or oxygen barrier properties, such as ITO, and combinations of these. In some embodiments, UHB materials or glass may be used, and in particular embodiments, UHB materials are used.

Backsheet 201 is a multilayer foil, which is made up of thin interface layer 242, barrier layer 244, and optional insulating layer 246. Suitable materials for use as backsheet 201 include commercially available multilayer packaging or lidding materials having moisture- and optionally oxygen-barrier properties in the form of films or sheets, especially heat-sealable materials. Lidding materials are typically composed of multiple thin polymer layers; lidding foils also include a metal foil, typically aluminum, sandwiched between polymer layers. One example of a suitable material for backsheet 201 is Tolas TPC-0814B lidding foil, produced by Tolas Healthcare Packaging, Feasterville, PA, a division of Oliver-Tolas, Grand Rapids, MI. Feedthrough apertures 248 and 249 are formed in backsheet 201 using any suitable methods, including punching, die cutting, and laser machining. The apertures may be round, of varied diameter, or of other shapes and aspect ratios depending on the layout of the device and other design factors.

Conductive cathode patch 250 and conductive anode patch 251 are composed of a sheet or foil of a conductive metal, such as aluminum. In the context of the present invention, the term "patch" refers to a piece or sheet of conductive material used to cover the feedthrough apertures. Patches 250 and 251 are of sufficient thickness and homogeneity to be impermeable to moisture, oxygen, and/or other vapors that may have a deleterious effect on the device; metal foils are suitable in many embodiments. Patches 250 and 251 are provided in a size that is substantially larger than feedthrough apertures 248 and 249 and are sealed to barrier layer 244 by interface layer 242 to form a seal zone 255. Patches 250 and 251 may be small in relation to the dimensions of combination optoelectronic device/transparent barrier layer 200, and may be round, although other shapes and sizes are acceptable. Although only two feedthrough apertures 248 and 249 are shown, in some embodiments, backsheet 201 may include multiple, that is, more than two, feedthrough apertures; if desired, patches 250 and 251 may be configured to cover multiple feedthrough apertures and thereby provide lateral busing of the electrical current. Materials suitable for use as electrical leads are known in the art, and may be used for patches 250 and 250, including aluminum, stainless steel, nickel and brass. In one example, patches 250 and 251 are fabricated from 0.001 inch (about 0.00254 cm) thick aluminum foil. In another example, the patches are fabricated from 0.001 stainless steel. The patches may be die cut from a foil sheet, but other means may be used, as long as the method prevents the formation of burrs at the cut edges of the patches. Conductive cathode patch 250 is electrically coupled to cathode contact 214 through electrically conducting element 260 and conductive anode patch 251 is electrically coupled to anode contact 216 through electrically conducting element 261.

Conductive elements 260 and 261 may be conveniently formed from an electrically conductive adhesive applied between contact 214 and patch 250 and contact 216 and patch 251. Conductive elements 260 and 261 can be formed using an electrically conductive adhesive placed by various means, including manual or automated means. An example of a suitable material for the conductive elements is Staystik 571, available from Cookson Electronics, Alpharetta, GA. The backsheet 201 and combination optoelectronic device/transparent barrier layer 200, patches 250 and 251, and conductive elements 214 and 216 are then aligned and layed up in preparation for lamination process at a temperature between 90°C and 130°C, preferably at 120°C, and a pressure of 1 psi (about 6,895 kPa) to 30 psi (about 206,843 kPa), and preferably 15 psi (about 103,421 kPa), for a time between 1 second and 10 minutes, and preferably 30 seconds. In the resulting hermetic electrical package, the patches 250 and 251 make electrical connections with contacts 214 and 216 thru conductive elements 260 and 261. Feedthrough apertures 248 and 249, patches 250 and 251 and contacts 260 and 261 may be centered and aligned, but this is not necessary in the general case. More generally, an offset orientation between these components may prove favorable in optimizing the device layout and the package design in many embodiments.

The exemplary materials are chosen so that a single lamination step can be used for bonding both conductive elements 260 and 261 and interface layer 242 under the same conditions. This is not however, a requirement for the packaging process. Moreover, it may be desirable to create a subassembly of elements prior to final lamination. For example, patches 250 and 251 could be attached to backsheet 201 in a first step, and in a subsequent step combination optoelectronic device/transparent barrier layer 200 may be laminated to backsheet 201.

Various lamination means are possible, including pouch lamination, roll lamination and hot press lamination, and process parameters depend on the equipment utilized. It is apparent that release films, press pads, and tooling plates are necessary to perform these laminations. Moreover, steps to clean and remove moisture from all package materials may be performed during processing. For example, backsheet 201 may be baked at 80°C for 12 hours under vacuum to eliminate moisture; however, other conditions may be used, including shorter times at higher temperatures under an inert atmosphere. The conditions will depend on the prior environmental exposure of the materials.

Patches 250 and 251 and backsheet 201 are joined in such a way that seal zone 255 provides a geometrically unfavorable ingress path for moisture and oxygen. The geometry of the seal zone 255 can be described as a ratio R, of seal zone path length to the thickness of interface layer 242. A high ratio provides a more difficult ingress path for a given material set. Depending on the shape, size, and alignment of apertures 248 and 249 and patches 250 and 251, ratio R, may vary depending on the particular path chosen for analysis. In one embodiment, apertures 248 and 249 had a diameter of 0.25 inch (about 0.635 cm) and patches 250 and 251 had a diameter of 1.25 inches (about 3.175 cm), so that seal zone path length 255 was 0.5 inches (about 1.27 cm), and ratio R, was approximately 500:1. The dimensions are not depicted to scale in FIG. 2. It can be foreseen that further reduction in the thickness of interface layer 242 (the permeation path between barrier 244 and patch 250 or patch 251) may enable substantially increased ratios R, and improved hermeticity of the feedthrough. In addition, it may be desirable to minimize the diameter of apertures 248 and 249, for example, reduction to a diameter of approximately 0.025 inch (about 0.0635 cm) using precision fabrication and alignment procedures. Depending on the layout of device 200, smaller apertures 248 and 249 may be desirable to achieve other design objectives such as maximizing the light-emitting area of the device. The minimum size of apertures 248 and 249 depends on the diameter of the electrical interconnection that extends therethrough to form a connection to an external bus.

Figure 2B shows an alternate embodiment where the multi-layer foil 201 includes a conductive metal layer 244. An aperture 249 is provided in 201, and patch 251 makes electrical contact through conductive element 261 to device electrode 216. In addition, interface layer 242 and insulating layer 246 have been selectively removed from multilayer foil 201 and electrical connection is made between conductive layer 244 and device electrode 214 by conductive element 260. In this embodiment, the number of apertures and patches are reduced, and the barrier film metal layer 244 is used as a conductor.

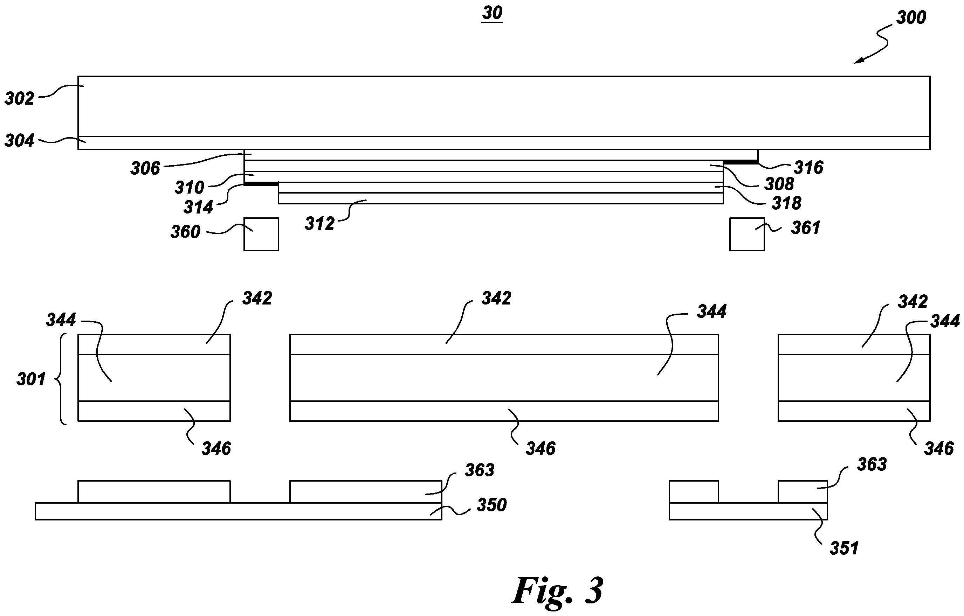

FIG. 3 shows an exploded view of hermetic electrical package 30 composed of combination optoelectronic device/transparent barrier layer 300 and second barrier layer (backsheet) 301. Combination 300 includes transparent substrate 302, transparent barrier layer 304, transparent conductive layer 306 forming a first electrode (typically an anode), optoelectronically active layer 308, and second electrode (cathode) 310, optional insulating layer 318, contacts 314 and 316 and optional second barrier layer 312. Patches 350 and 351 are located on the surface of backsheet 301 opposite combination layer 300 and are joined to backsheet 301 by means of interface layer 363, which is an adhesive. Materials suitable for use in interface layer 363 have low permeability to at least moisture and oxygen. In addition, the materials are processable at relatively low temperatures, that is, less than 150°C, preferably less than 120°C. In one example, PRIMACOR 3460 thermoplastic adhesive, available from Dow Chemical, Midland, Michigan, is used to prepare a 0.001 inch (about 0.00254 cm) thick layer. Patches 350 and 351 (with optional interface layer 363) are joined to backsheet 301 by lamination at a temperature between 95°C and 125°C, preferably 115°C, and a pressure of 5 psi (about 34,474 kPa) to 20 psi (about 137,895 kPa), preferably 10 psi (about 68,948 kPa), for a time between 1 minute and 10 minutes, preferably about 2 minutes. Lamination methods listed above may be used, and release films, press pads, and tooling plates may be used to perform these laminations. Many alternate materials are suitable for interface layer 363, including thermosets and other thermoplastic adhesives, especially those formulated to have low moisture and oxygen permeability for packaging applications. Backsheet 301 enables ratio R, to be generally larger compared to backsheet 401 because the size of patches 350 and 351 is not limited by size and location of the combination optoelectronic device/transparent barrier layer 300 and contacts 314 and 316. Patches 350 and 351 may extend to or beyond the edge of the package as shown. In one embodiment, the path length is 1.0 inches (about 2.54 cm), and the thickness of interface layer 363 is 0.001 inch (about 0.00254 cm), so ratio R₁ is 1000:1, resulting in a geometry that is more favorable for limiting ingress.

The next step is align and layup device 300, backsheet 301, and conductive elements 360 and 361 and patches 350 and 351. These materials can be laminated at the conditions previously described for bonding backsheet 301. As an alternative lamination sequence, backsheet 301 is joined to device 300 in one lamination step. This results in a semi-hermetic package, where device 300 is somewhat protected from mechanical damage and moisture ingress. The subsequent step of providing conductive elements 360 and 361 and patches 350 and 351 with interface layer 342 can be performed after a lapse of time in a subsequent lamination process to form a fully hermetic package. Alternately, all components may be assembled in a single lamination step.

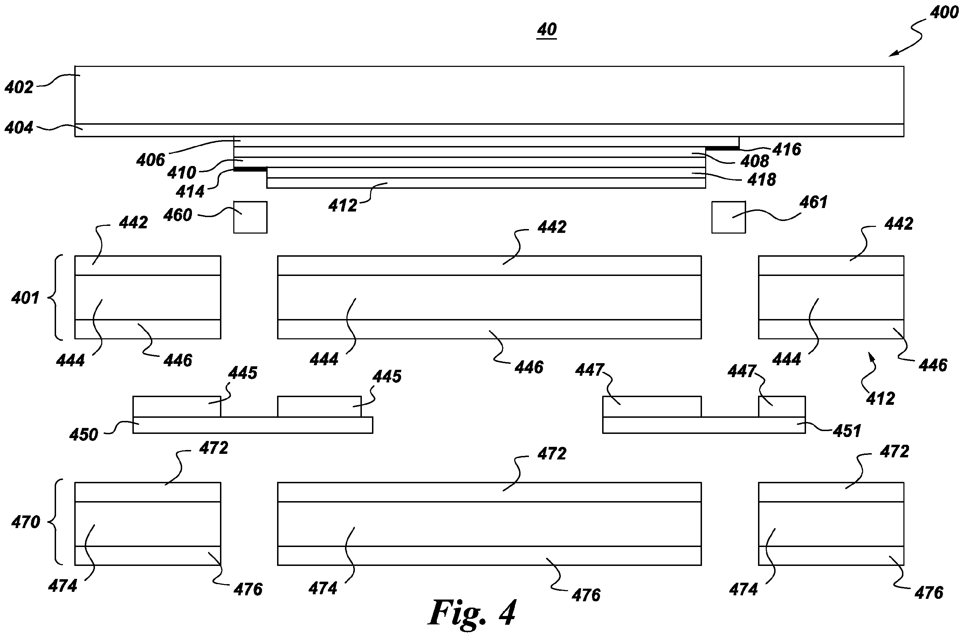

FIG. 4 is a partially exploded view of hermetic electrical package 40 comprising combination optoelectronic device/transparent barrier layer sheet 400, second barrier layer (backsheet) 401 and electrically conducting elements 460 and 461. Combination 400 includes transparent substrate 402, transparent barrier layer 404, transparent conductive layer 406 forming a first electrode (typically an anode), optoelectronically active layer 408, and second electrode (cathode) 410, optional insulating layer 418, contacts 414 and 416 and optional second barrier layer 412. Patches 450 and 451 are provided with interface layers 445 and 447, and are sealed in an embedded configuration between multilayer foils 401 and470. Alternately interface layers 446 and 447 may be omitted so that patches 450 and 451 are embedded between 401 and 407 and then sealed by 472. This configuration provides a high ratio R, as described for backsheet 301. A suitable material for multilayer foil 401, comprising insulating layer 442, barrier layer 444, and interface layer 446, and 470, comprising insulating layer 472, barrier layer 474, and interface layer 476, is Tolas TPC-0814B lidding foil. All of the layers may be laminated together in a single step, or combination sheet 400 may be laminated to backsheet 401 and then multilayer foil 470 may be added in subsequent lamination step. The lamination steps are typically performed at a temperature between 90°C and 130°C, particularly at about 120°C, and a pressure of 1 psi (about 6,895 kPa) to 30 psi (about 206,843 kPa), and particularly at about 15 psi (about 103,421 kPa), for a time between 10 seconds and 10 minutes, and particularly for about 30 seconds. Lamination means as discussed above may be used, and may depend on the equipment. As mentioned, various sub-components can be fabricated in sequential lamination steps.

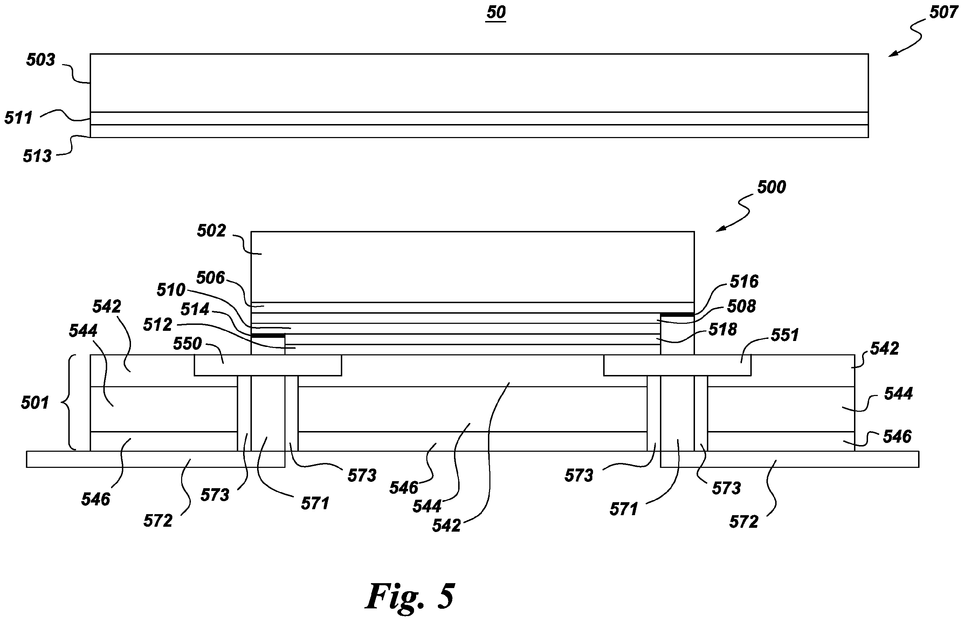

FIG. 5 shows a partially exploded cross-sectional view of hermetic electrical package 50 composed of optoelectronic device/ sheet 500, second barrier layer (backsheet) 501 and front sheet 507. Combination 500 includes transparent substrate 502, transparent conductive layer 506 forming a first electrode (typically an anode), optoelectronically active layer 508, and second electrode (cathode) 510, optional insulating layer 518, contacts 514 and 516 and optional second barrier layer 512. Sheet 500 does not include a barrier layer. Instead, a barrier layer may be included as part of front sheet 507, which is composed of transparent substrate 503, barrier film 511, and optional interface layer 513. Front sheet 507 may be used in a hermetic package to provide increased versatility and performance improvements. In particular, front sheet 507 obviates the needed for an ultra-high barrier layer as part of combination optoelectronic device/transparent barrier layer 500, thus limiting the opportunity for damage to the barrier during device manufacturing. Suitable adhesives should be optically clear, provide adhesion to 500 and 507, and have processing conditions suitable for low cost high-speed production. In one example, front sheet 507 was fabricated by coating an adhesive to a barrier layer as described in US 7,015,640, disposed on a UHB substrate then drying, using AD-COTE 37T77 adhesive from Rohm & Haas Company, Philadelphia, PA. Various means of coating are possible, including wire rod, doctor blade and spin coating. Spin coating at 700 rpm and then drying at 120°C for 15 minutes provided a coating ranging from approximately 1 to 5µm, with some variation across the surface. A final coating thickness of 1µm -30µm may be used, with a preferred uniform thickness in the range of 2-10µm. The interface layer may be applied to the combination of substrate 502 and barrier 504 in a roll-to-roll process and provides some protection for the barrier layer during handling and take up. Moreover, layer 513 may provide improved adhesion between adhesive 542 and barrier layer 502, thus providing optical coupling between 507 and 500 and improving package hermeticity and resulting device reliability.

FIG. 5 also depicts external bus elements comprising conductive elements 571, conductive lines 572, and insulating layers 573. Methods and materials for constructing electrical leads on a package are known in the art. In one example, conductive element 571 is fabricated from TRA-DUCT 2902 conductive adhesive, Emerson & Cuming, Billerica, MA and wire 902 is 0.001 inch (about 0.00254 cm) thick by 0.125 inch (about 0.3175 cm) wide copper. Conductive element 572 is formed from 0.001 inch (about 0.00254 cm) thick by 0.125 inch (about 0.3175 cm) wide copper wire. Insulating layer 573 is fabricated from generic 0.003 inch (about 0.00762 cm) thick tape comprising 0.001 inch (about 0.00254 cm) polyimide film and 0.002 inch (about 0.00508 cm) thick silicone pressure sensitive adhesive. As an alternative to conductive elements 571 and conductive lines 572, wirebonding may be used to connect a wire directly to patches 550 and 551. Specifically, wedge bonding with aluminum wire can be accomplished with some combination of heat and pressure and ultrasonic energy to form a weld between the patch 550 and 551 and the aluminum wire. Wire diameter would be sized for the electrical requirements of the device, and could range from less than 25 micron to several hundred microns diameter. The other end of the wire would terminate at the power supply, or some intermediate conductor.

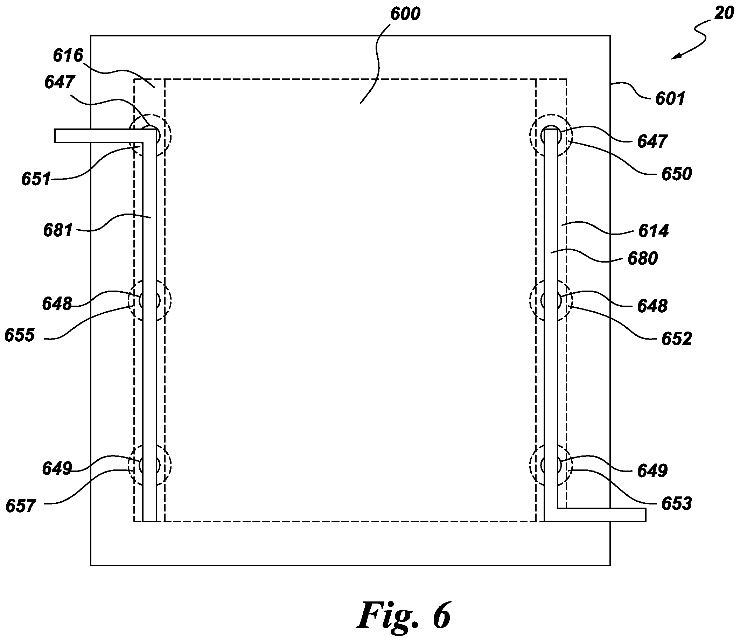

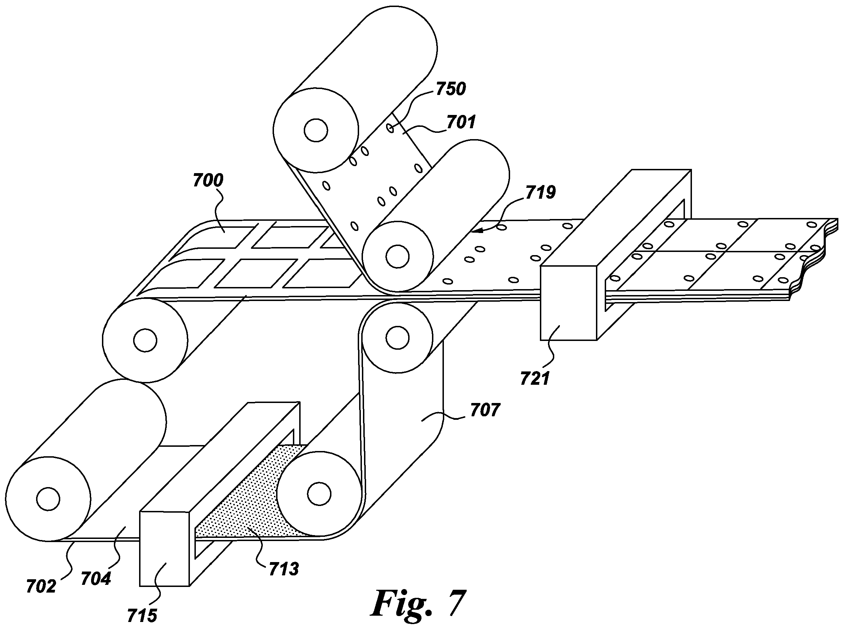

FIG. 6 is a plan view of the back side of hermetic electric package 50. Combination optoelectronic device/transparent barrier layer 600 is shown in phantom beneath second barrier layer (backsheet) 601. Multiple feedthrough apertures 647, 648 and 649 and conductive cathode patches 650, 652 and 653 are connected between cathode contact 614 and external cathode bus 680. Multiple feedthrough apertures 647, 648 and 649 and conductive anode patches 651, 655 and 657 are connected between anode contact 616 and external anode bus 681. In alternate embodiments, multiple devices may be connected via external anode and cathode buses within a single package. Various configurations are possible using this packaging method. Device design elements shown in FIG. 1A and 1B can be used to configure devices or sets of devices to achieve various objectives, including tailoring the overall voltage - current characteristics, combining individual devices in a tiling configuration and to provide tuning of brightness levels of individual devices. Some designs may require common busing of many connections points, and other designs may require individual connections to each connection point. Whereas the figures and examples describe the fabrication in sequential batch processes, the package design is compatible with continuous flow production. FIG. 7 depicts schematically a roll-to-roll process for manufacturing a hermetic electrical package according to the present invention. Sheet 700 is composed of multiple individual devices disposed on a substrate, without a transparent barrier layer. The number and configuration of the OLED elements on OLED sheet 700 is not critical, and, in some embodiments, the sheet may be composed of a single large element. sheet 700 may be prefabricated and provided in roll format, as shown, or may be fabricated on the same roll-to-roll line. Backsheet 701 is composed of a multilayer film as described previously, and provided in roll format. Front sheet 707 is formed by passing combination substrate 702 with barrier layer 704 through coating station 715 where interface layer 713 is applied to the barrier layer 704. Alternately, front sheet 707 may be precoated and provided in roll format. In some embodiments, sheet 700 may include a transparent barrier layer; and barrier layer 704 is optional, in other embodiments, front sheet 707 may be omitted if OLED sheet 700 has a barrier layer, and only sheet 700 and backsheet 701 are laminated together. Backsheet 701 includes feedthrough apertures 750 and may include patches (not shown), which may be positioned on the surface, facing sheet 700 or opposite to sheet 700, or the patches may be placed in a later operation. A conductive adhesive is applied (not shown) to the cathodes and anodes of the device elements of sheet 700 to provide a means for electrically coupling the conductive anode patches to the anodes and the conductive cathode patches to the cathodes. The three components are brought together in lamination station 719, with sheet 700 sandwiched between barrier layer (backsheet) 701 and front sheet 707, laminated under heat and pressure and then segmented if desired in segmentation station 721. In embodiments where front sheet 707 is omitted, only OLED sheet 700 and backsheet 701 are laminated. If desired, a third barrier layer (not shown) may be joined to backsheet 701, particularly if patches are positioned on the surface opposite to sheet 700 and so may sandwiched between the backsheet 701 and the third barrier layer. External bus components are provided in a subsequent operation and additional conductive adhesive may be applied to patches if necessary to complete the hermetic electric package. In an alternate embodiment, backsheet 701 may be provided with feedthrough apertures 750 but without patches, which may be applied in a post-lamination operation, and in yet other embodiments, the feedthrough apertures are formed after sheets 700, 701 and 707 are joined, and patches are applied thereafter.

## Claims

1. A hermetic electrical package (30) comprising:
a first transparent barrier layer (304);
a second barrier layer (301) bonded to the first transparent barrier layer (304), and defining a plurality of feedthrough apertures;
an optoelectronic device sandwiched between the first and second barrier layers, the optoelectronic device comprising an anode (306), a photoelectrically active layer (308), and a cathode (310);
at least one conductive patch (350, 351) electrically coupled to the cathode or anode and disposed across at least one feedthrough aperture;
**characterized in that** the hermetic electrical package further comprises
an adhesive layer (363),
wherein the at least one conductive patch (350,351) is bonded to the second barrier layer (301) through the adhesive layer (363), and further is disposed at a side, opposite to the optoelectronic device, of the second barrier layer (301) and covers the at least one feedthrough aperture, the at least one conductive patch (350, 351) and the adhesive layer (363) are formed by different materials.

2. A hermetic electrical package (30) according to claim 1, wherein the second barrier layer (301) comprises a multilayer structure.

3. A hermetic electrical package (30) according to claim 2, wherein the multilayer structure comprises at least one metal layer.

4. A hermetic electrical package (30) according to claim 3, wherein the multilayer structure additionally comprises at least one adhesive layer.

5. A hermetic electrical package (30) according to claim 3, wherein the at least one metal layer comprises aluminum, stainless steel or brass.

6. A hermetic electrical package (30) according to claim 1, comprising a plurality of conductive anode patches (351).

7. A hermetic electrical package (30) according to claim 1, comprising a plurality of conductive cathode patches (350).

8. A hermetic electrical package (30) according to claim 1, additionally comprising a third barrier layer (470) disposed on the second barrier layer (301).

9. A hermetic electrical package (30) according to claim 8, wherein the at least one conductive patch (350, 351) is sandwiched between the second barrier layer (301) and the third barrier layer (470).

10. A hermetic electrical package (30) according to claim 1, additionally comprising an external bus electrically coupled to the at least one conductive patch (350, 351).

11. A process for manufacturing a hermetic electrical package (30), said process comprising:
providing an optoelectronic device comprising a cathode (310), an anode (306) and an optoelectronically active layer (308);
sandwiching the optoelectronic device between a first transparent barrier layer (304) and a second barrier layer (301), wherein the second barrier layer (301) is bonded to the first transparent barrier layer (304) and a plurality of feedthrough apertures is formed in the second barrier layer (301);
disposing at least one conductive patch (350, 351) on the second barrier layer (301) through an adhesive layer (363), wherein the at least one conductive patch (350, 351) is disposed at a side, opposite to the optoelectronic device, of the second barrier layer (301) and covers at least one feedthrough aperture, and the at least one conductive patch (350,351) and the adhesive layer (363) are formed by different materials;
electrically coupling the at least one conductive patch (350, 351) to the cathode (310) or the anode (306).

12. A hermetic electrical package (30) according to claim 1 further comprising:
an external bus electrically coupled to each of the conductive patches (350, 351).

## Patentansprüche

1. Hermetische elektrische Verpackung (30) mit:
einer ersten transparenten Barrierenschicht (304);
einer zweiten Barrierenschicht (301), die an die erste transparente Barrierenschicht (304) gebondet ist und eine Vielzahl von Durchführungsöffnungen definiert;
eine optoelektronische Vorrichtung, die sandwichartig zwischen der ersten und der zweiten Barrierenschicht angeordnet ist, wobei die optoelektronische Vorrichtung eine Anode (306), eine photoelektrisch aktive Schicht (308) und eine Kathode (310) aufweist;
wenigstens eine leitfähige Füllfläche (350, 351), die elektrisch an die Kathode oder an die Anode gekoppelt ist und über wenigstens einer Durchführungsöffnung angeordnet ist;
**gekennzeichnet dadurch, dass** die hermetische elektrische Verpackung weiter aufweist
eine Klebeschicht (363),
wobei die wenigstens eine leitfähige Füllfläche (350, 351) an die zweite Barrierenschicht (301) durch die Klebeschicht (363) gebondet ist und weiter angeordnet ist an einer der optoelektronischen Vorrichtung gegenüberliegenden Seite der zweiten Barrierenschicht (301) und die wenigstens eine Durchführungsöffnung abdeckt, wobei die wenigstens eine leitfähige Füllfläche (350, 351) und die Klebeschicht (363) aus unterschiedlichen Materialien gebildet sind.

2. Hermetische elektrische Verpackung (30) gemäß Anspruch 1, wobei die zweite Barrierenschicht (301) eine mehrschichtige Struktur aufweist.

3. Hermetische elektrische Verpackung (30) gemäß Anspruch 2, wobei die mehrschichtige Struktur wenigstens eine Metallschicht aufweist.

4. Hermetische elektrische Verpackung (30) gemäß Anspruch 3, wobei die mehrschichtige Struktur zusätzlich wenigstens eine Klebeschicht aufweist.

5. Hermetische elektrische Verpackung (30) gemäß Anspruch 3, wobei die wenigstens eine Metallschicht Aluminium, Edelstahl oder Messing aufweist.

6. Hermetische elektrische Verpackung (30) gemäß Anspruch 1 mit einer Vielzahl von leitfähigen Anodenfüllflächen (351).

7. Hermetische elektrische Verpackung (30) gemäß Anspruch 1 mit einer Vielzahl leitfähiger Kathodenfüllflächen (350).

8. Hermetische elektrische Verpackung (30) gemäß Anspruch 1 zusätzlich mit einer dritten Barrierenschicht (470), die auf der zweiten Barrierenschicht (301) angeordnet ist.

9. Hermetische elektrische Verpackung (30) gemäß Anspruch 8, wobei die wenigstens eine leitfähige Füllfläche (350, 351) sandwichartig zwischen der zweiten Barrierenschicht (301) und der dritten Barrierenschicht (470) angeordnet ist.

10. Hermetische elektrische Verpackung (30) gemäß Anspruch 1 zusätzlich mit einem elektrischen Bus, der elektrisch mit der wenigstens einen leitfähigen Füllflächen (350, 351) gekoppelt ist.

11. Verfahren zum Herstellen einer hermetischen elektrischen Verpackung (30) wobei das Verfahren aufweist:
Bereitstellen einer optoelektrischen Vorrichtung mit einer Kathode (310), einer Anode (306) und einer optoelektrisch aktiven Schicht (308);
sandwichartiges Anordnen der optoelektrischen Vorrichtung zwischen einer ersten transparenten Barrierenschicht (304) und einer zweiten Barrierenschicht (301), wobei die zweite Barrierenschicht (301) an die erste transparente Barrierenschicht (304) gebondet ist und eine Vielzahl von Durchführungsöffnungen in der zweiten Barrierenschicht (301) gebildet ist;
Anordnen wenigstens einer leitfähigen Füllfläche (350, 351) auf der zweiten Barrierenschicht (301) durch eine Klebeschicht (363), wobei die wenigstens eine leitfähige Füllfläche (350, 351) angeordnet ist an einer der optoelektrischen Vorrichtung gegenüberliegenden Seite der zweiten Barrierenschicht (301) und wenigstens eine Durchführungsöffnung bedeckt, und wobei die wenigstens eine leitfähige Füllfläche (350, 351) und die Klebeschicht (363) durch unterschiedliche Materialien gebildet ist;
elektrisches Koppeln der wenigstens einen leitfähigen Füllfläche (350, 351) an die Kathode (310) oder die Anode (306).

12. Hermetische elektrische Verpackung (30) gemäß Anspruch 1 weiter mit:
einem externen Bus, der elektrisch mit jeder der leitfähigen Füllflächen (350, 351) gekoppelt ist.

## Revendications

1. Module électrique hermétique (30) comprenant :
une première couche de barrière transparente (304) ;
une deuxième couche de barrière (301) qui est liée à la première couche de barrière transparente (304) et qui définit une pluralité d'ouvertures sous forme de trous d'interconnexion ;
un dispositif optoélectronique qui est pris en sandwich entre les première et deuxième couches de barrière, le dispositif optoélectronique comprenant une anode (306), une couche active photoélectriquement (308) et une cathode (310) ;
au moins un patch conducteur (350, 351) qui est couplé électriquement à la cathode ou à l'anode et qui est disposé au travers d'au moins une ouverture sous forme de trou d'interconnexion ;
**caractérisé en ce que** le module électrique hermétique comprend en outre :
une couche adhésive (363) ; dans lequel :
l'au moins un patch conducteur (350, 351) est lié à la deuxième couche de barrière (301) par l'intermédiaire de la couche adhésive (363), et il est en outre disposé au niveau d'un côté, qui est opposé au dispositif optoélectronique, de la deuxième couche de barrière (301) et il recouvre l'au moins une ouverture sous forme de trou d'interconnexion, l'au moins un patch conducteur (350, 351) et la couche adhésive (363) sont formés en des matériaux différents.

2. Module électrique hermétique (30) selon la revendication 1, dans lequel la deuxième couche de barrière (301) comprend une structure à multiples couches.

3. Module électrique hermétique (30) selon la revendication 2, dans lequel la structure à multiples couches comprend au moins une couche en métal.

4. Module électrique hermétique (30) selon la revendication 3, dans lequel la structure à multiples couches comprend de façon additionnelle au moins une couche adhésive.

5. Module électrique hermétique (30) selon la revendication 3, dans lequel l'au moins une couche en métal comprend de l'aluminium, de l'acier inoxydable ou du laiton.

6. Module électrique hermétique (30) selon la revendication 1, comprenant une pluralité de patchs d'anode conducteurs (351).

7. Module électrique hermétique (30) selon la revendication 1, comprenant une pluralité de patchs de cathode conducteurs (350).

8. Module électrique hermétique (30) selon la revendication 1, comprenant de façon additionnelle une troisième couche de barrière (470) qui est disposée sur la deuxième couche de barrière (301).

9. Module électrique hermétique (30) selon la revendication 8, dans lequel l'au moins un patch conducteur (350, 351) est pris en sandwich entre la deuxième couche de barrière (301) et la troisième couche de barrière (470).

10. Module électrique hermétique (30) selon la revendication 1, comprenant de façon additionnelle un bus externe qui est couplé électriquement à l'au moins un patch conducteur (350, 351).

11. Procédé pour la fabrication d'un module électrique hermétique (30), ledit procédé comprenant :
la fourniture d'un dispositif optoélectronique qui comprend une cathode (310), une anode (306) et une couche active optoélectroniquement (308) ;
la prise en sandwich du dispositif optoélectronique entre une première couche de barrière transparente (304) et une deuxième couche de barrière (301), dans lequel la deuxième couche de barrière (301) est liée à la première couche de barrière transparente (304) et une pluralité d'ouvertures sous forme de trous d'interconnexion sont formées dans la deuxième couche de barrière (301) ;
la disposition d'au moins un patch conducteur (350, 351) sur la deuxième couche de barrière (301) par l'intermédiaire d'une couche adhésive (363), dans lequel l'au moins un patch conducteur (350, 351) est disposé au niveau d'un côté, qui est opposé au dispositif optoélectronique, de la deuxième couche de barrière (301) et il recouvre au moins une ouverture sous forme de trou d'interconnexion, et l'au moins un patch conducteur (350, 351) et la couche adhésive (363) sont formés en des matériaux différents ; et
le couplage électrique de l'au moins un patch conducteur (350, 351) à la cathode (310) ou à l'anode (306).

12. Module électrique hermétique (30) selon la revendication 1, comprenant en outre :
un bus externe qui est couplé électriquement à chacun des patchs conducteurs (350, 351).
